# EUROPEAN PATENT APPLICATION

(11) **EP 2 549 175 A1**
(43) Date of publication of application: **23.01.2013**
(21) Application number: 11755833.8
(22) Date of filing: 03.03.2011
(51) Int. Cl.: F21S 8/10, F21V 31/03

(54) **VENTILATION MEMBER AND METHOD OF MANUFACTURING SAME**

(30) Priority: 19.03.2010 JP 2010064111
(71) Applicant: Nitto Denko Corporation, Osaka 567-8680 (JP)
(72) Inventor: UEMURA, Kou, Ibaraki-shi Osaka 567-8680 (JP); YANO, Youzou, Ibaraki-shi Osaka 567-8680 (JP)
(74) Representative: Intès, Didier Gérard André
(86) International application number: PCT/JP2011/001262
(87) International publication number: WO 2011/114640

(57) **Abstract**

A vent member (10) includes: a support body (4) having a vent passage (a vent hole (3)) between an interior space (22) and an exterior space (24) of a housing (20); a gas-permeable membrane (2) disposed on the support body (4) to close the vent passage (3) on the side of the exterior space (24); a cover (6) attached to the support body (4) to protect the gas-permeable membrane (2); and a laser welding portion (12) that joins the cover (6) and the support body (4) together. For example, the support body (4) is made of a first material that relatively easily absorbs laser light for forming a laser welding portion (12). The cover (6) is made of a second material that absorbs less laser light than the first material and can transmit laser light.

## Description

### TECHNICAL FIELD

The present invention relates to a vent member and a method of manufacturing the same.

### BACKGROUND ART

Vent members are attached to housings containing automotive electrical components such as lamps, motors, sensors, switches, and ECUs (electronic control units). The vent member not only ensures ventilation between the inside and outside of the housing to prevent malfunctions caused by pressure change but also prevents foreign substances from entering the housing. Patent Literatures 1 and 2 disclose examples of such a vent member. Fig. 9 shows a vent member disclosed in Patent Literature 1.

A vent member 101 includes a support body 103, a gas-permeable membrane 102 disposed on the support body 103, and a cover 104 that covers the gas-permeable membrane 102. The vent member 101 is fixed to an opening 107 of a housing 106 via an O-ring 105. A leg portion 108 of the support body 103 is engaged with the opening 107 to prevent detachment of the vent member 101 from the housing 106. The cover 104 is provided with a plurality of hooks 104a. The hooks 104a are engaged with the outer periphery of the support body 103, so that the cover 104 is fixed to the support body 103.

### CITATION LIST

### Patent Literature

Patent Literature 1 JP 2004-47425 A
Patent Literature 2 JP 2007-141629 A

### SUMMARY OF INVENTION

### Technical Problem

With the recent reduction in size and thickness of automotive components, there has been a need for simple and easy-to-produce vent members.

### Solution to Problem

The present invention provides a vent member attachable to a housing with a vent opening. The vent member includes: a support body having a vent passage between an interior space and an exterior space of the housing; a gas-permeable membrane disposed on the support body to close the vent passage on a side of the exterior space; a cover attached to the support body to protect the gas-permeable membrane; and a laser welding portion that joins the cover and the support body together.

In another aspect, the present invention provides a method of manufacturing a vent member attachable to a housing with a vent opening. The method includes the steps of: preparing a support body having a vent passage between an interior space and an exterior space of the housing, a gas-permeable membrane capable of closing the vent passage on a side of the exterior space, and a cover to be attached to the support body to protect the gas-permeable membrane; placing the gas-permeable membrane and the cover respectively at predetermined positions with respect to the support body; and irradiating an assembly composed of the support body, the gas-permeable membrane and the cover with laser light so that the laser light passing through the cover melts a part of the support body or the laser light passing through the support body melts a part of the cover to form a laser welding portion for joining the cover and the support body together.

### Advantageous Effects of Invention

According to the present invention, the cover is joined to the support body by the laser welding portion. This makes it possible to eliminate a structure such as an engaging portion for fixing the cover to the support body. Therefore, the present invention can provide a more simply structured vent member than conventional ones. A structure such as an engaging portion may, of course, be provided. In addition, the formation of a joint between the cover and the support body by laser welding makes it easier to automate the manufacturing process of the vent member.

### BRIEF DESCRIPTION OF DRAWINGS

Fig. 1 is an exploded perspective view of a vent member according to en embodiment of the present invention.
Fig. 2 is a sectional view of the vent member shown in Fig. 1.
Fig. 3 is a sectional view of a gas-permeable membrane.
Fig. 4 is a partially enlarged sectional view of the vent member shown in Fig. 1.
Fig. 5A is a diagram showing a manufacturing process of the vent member shown in Fig. 1.
Fig. 5B is a diagram showing a manufacturing process following Fig. 5A.
Fig. 5C is a diagram showing a manufacturing process following Fig. 5B.
Fig. 6 is a sectional view of a vent member according to a modification.
Fig. 7 is a diagram showing a laser irradiation step.
Fig. 8 is a sectional view of a cover according to the modification.
Fig. 9 is a side view of a conventional vent member.

### DESCRIPTION OF EMBODIMENTS

Hereinafter, an embodiment of the present invention is described with reference to the accompanying drawings.

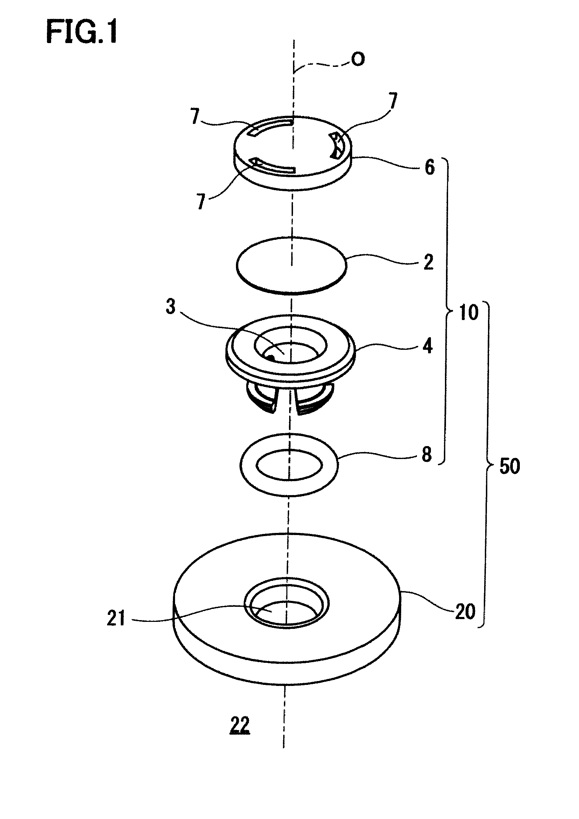

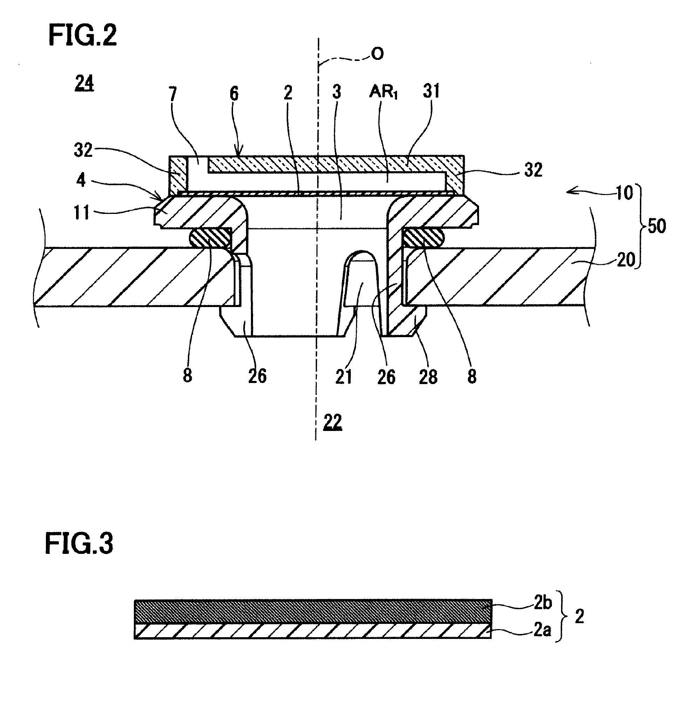

As shown in Fig. 1 and Fig. 2, a vent member 10 of the present embodiment includes a gas-permeable membrane 2, a support body 4, a cover 6 and a seal ring 8. A vent structure 50 is composed of a housing 20 having an opening 21 for ventilation and the vent member 10 attached to the opening 21. The housing 20 has an interior space 22 that requires ventilation. Gas can pass between the interior space 22 and the exterior space 24 through the gas-permeable membrane 2. Examples of the housing 20 include an ECU (Electric Control Unit) box and a lamp box for an automobile. Fig. 1 and Fig. 2 show only a part of the housing 20.

The gas-permeable membrane 2, the support body 4, and the cover 6 each have a circular or regular polygonal shape in plan view. An axis O passes through the center of each of the gas-permeable membrane 2, the support body 4, and the cover 6. With respect to the axial direction, the side on which the gas-permeable membrane 2 is located is the upper surface side of the support body 4, and the side on which the support body 4 faces the housing 20 is the lower surface side of the support body 4. The thickness direction of the gas-permeable membrane 2 is parallel to the axis O. The direction perpendicular to the axis O is defined as the radial direction of the vent member 10, in other words, the radial direction of the gas-permeable membrane 2.

As shown in Fig. 2, the support body 4 has a base portion 11 and a leg portion 26. The base portion 11 is a portion that supports the gas-permeable membrane 2, and has an almost disc shape. A through-hole 3 is formed in the base portion 11 to serve as a gas passage between the interior space 22 and the exterior space 24. The leg portion 26 is a portion used to fix the vent member 10 to the housing 20. The leg portion 26 is formed integrally with the base portion 11 and extends downward from the base portion 11. The leg portion 26 is divided into a plurality of portions (3 portions in the present embodiment) along the circumferential direction of the through hole 3. In the vent structure 50, the leg portion 26 is fitted in the opening 21.

The gas-permeable membrane 2 is disposed on the base portion 11 so as to close the through-hole 3 on the exterior space 24 side. The structure and material of the gas-permeable membrane 2 are not particularly limited. As the gas-permeable membrane 2, a membrane having properties that allow gas to pass therethrough and prevent liquid from passing therethrough can be used. As shown in Fig. 3, in the present embodiment, the gas-permeable membrane 2 has a membrane body 2a and a reinforcing member 2b laminated to the membrane body 2a. The strength of the gas-permeable membrane 2 is increased by the presence of the reinforcing member 2b. The gas-permeable membrane 2 may consist only of the membrane body 2a, of course.

The membrane body 2a may be subjected to liquid-repellent treatment such as oil-repellent treatment or water-repellent treatment. This liquid-repellent treatment can be performed by applying a substance having a low surface tension to the membrane body 2a, followed by drying and then curing. A liquid-repellent agent capable of forming a coating film having a lower surface tension than that of the membrane body 2a, for example, a liquid-repellent agent containing a polymer having a perfluoroalkyl group, can be suitably used for the liquid-repellent treatment. The liquid-repellent agent is applied to the membrane body 2a by a known method such as impregnation or spraying.

A typical example of the membrane body 2a is a porous membrane made of fluororesin or polyolefin. In terms of ensuring sufficient waterproofness, a resin porous membrane having an average pore size of 0.01 to 10 µm can be used as the membrane body 2a.

Examples of fluororesins suitable for the membrane body 2a include polytetrafluoroethylene (PTFE), polychlorotrifluoroethylene, tetrafluoroethylene-hexafluoropropylene copolymer and tetrafluoroethylene-ethylene copolymer. Examples of polyolefins suitable for the membrane body 2a include polymers of monomers such as ethylene, propylene and 4-methylpentene-1,1 butene, and copolymers of these monomers. A nanofiber film porous material using polyacrylonitrile, nylon, or polylactic acid also can be used. Above all, PTFE is preferred because it can not only ensure high permeability even with a small area but also exhibit excellent ability to prevent foreign substances from entering the inside of the housing. PTFE porous membranes can be produced by a known molding method such as stretching or extraction.

The reinforcing member 2b can be a member made of a resin such as polyester, polyethylene, or aramid. The form of the reinforcing material 2b is not particularly limited as long as its permeability can be maintained. For example, the reinforcing member 2b is in the form of a woven fabric, a nonwoven fabric, a net, a mesh, a sponge, a foam, or a porous material. The membrane body 2a may be laminated to the reinforcing member 2b by heat lamination, heat welding or ultrasonic welding, or with an adhesive.

The thickness of the gas-permeable membrane 2 is, for example, in the range of 1 µm to 5 mm, in view of the strength and ease of handling. The gas permeability of the gas-permeable membrane 2 is, for example, in the range of 0.1 to 300 sec/100 cm³ in terms of Gurley value obtained by the Gurley test method prescribed in JIS (Japanese Industrial Standards) P 8117. The resistance to water pressure of the gas-permeable membrane 2 is, for example, 1.0 kPa or more.

The seal ring 8 is provided at the base of the leg portion 26. In the present embodiment, the seal ring 8 is made of a material having rubber elasticity, for example, an elastomer such as nitrile rubber, ethylene-propylene rubber, silicone rubber, fluororubber, acrylic rubber, or hydrogenated nitrile rubber. The seal ring 8 may be made of another rubber elastic material, such as a foam, instead of an elastomer.

When the leg portion 26 of the support body 4 is inserted into the opening 21 of the housing 20, the support body 4 is pushed back in the direction in which it is separated from the housing 20 by the elastic force of the seal ring 8 interposed between the support body 4 and the housing 20. In this case, the leg portion 26 is engaged with the housing 20 on the interior space 22 side of the housing 20 to prevent detachment of the vent member 10 from the housing 20. The portion corresponding to the seal ring 8 may be provided integrally with the support body 4 by a technique such as two-color molding or insert molding. The seal ring 8 may be bonded to the support body 4.

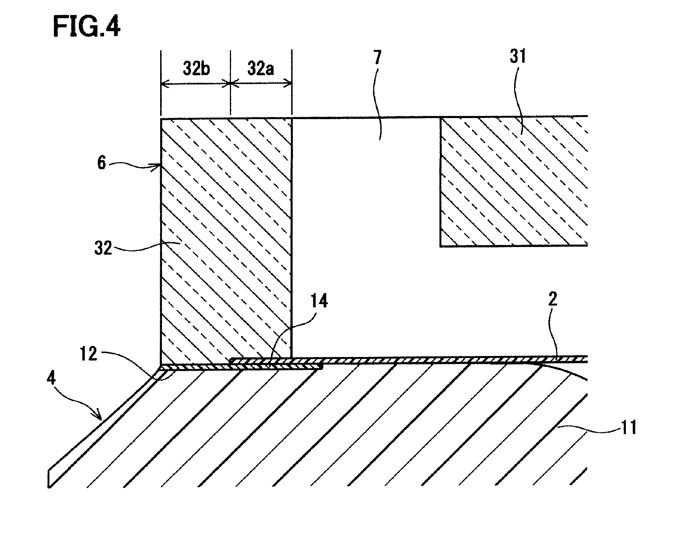

The cover 6 is attached to the support body 4 to protect the gas-permeable membrane 2. As the interior space of the cover 6, a space AR₁ is formed between the gas-permeable membrane 2 and the cover 6. The space AR₁ also serves as a gas passage between the interior space 22 and the exterior space 24. In the present embodiment, the cover 6 is fixed to the support body 4 by laser welding. Specifically, as shown in Fig. 4, a first laser welding portion 12 is formed between the cover 6 and the support body 4 to join them together. Furthermore, the gas-permeable membrane 2 also is fixed to the support body 4 by laser welding. Specifically, a second laser welding portion 14 is formed between the gas-permeable membrane 2 and the support body 4 to join them together. The second laser welding portion 14 may be formed continuously from the first laser welding portion 12 in the radial direction of the gas-permeable membrane 2. The second laser welding portion 14 may also be formed away from the first laser welding portion 12. In the former case (that is, in the example shown in Fig. 4), the first laser welding portion 12 and the second laser welding portion 14 have, as a whole, a single ring shape in plan view. In the latter case, the first laser welding portion 12 and the second laser welding portion 14 have a double ring shape in plan view.

In the present embodiment, the support body 4 is made of a first material that relatively easily absorbs laser light for forming the laser welding portion 12. The cover 6 is made of a second material that absorbs relatively less laser light than the first material and can transmit laser light. The first and second materials contain, for example, the same type or different types of resins, as their main components. Since the support body 4 and the cover 6 are made of materials having properties different from each other, the high-quality laser welding portion 12 can be formed relatively easily. In the case where the same resin is used as the main component of the first material and that of the second material, respectively, the degree of absorption of laser light can be adjusted by, for example, the amounts and types of additives in the resin. Materials other than resin, for example, glass and metal also can be used, of course. The "main component" means a component with the highest mass content.

As a resin for the first material, thermoplastic resins, such as PBT (polybutylene terephthalate), PA (polyamide) and PET (polyethylene terephthalate), and thermosetting resins such as EPDM (ethylene propylene diene rubber) and silicone rubber can be used suitably. A colorant (a dye and/or a pigment) can be mixed in the resin so that the resin can absorb more laser light. As the colorant, an organic or inorganic colorant, or a combination of these can be used. The calorific value at laser irradiation can be controlled by adjusting the content of the colorant in the resin. For example, a combined use of a dye-based absorbing colorant and a pigment-based absorbing colorant makes it easier to control the calorific value at laser light irradiation. In addition to these, pigments such as carbon black and titanium white, reinforcing fillers such as glass particles and glass fibers, and additives such as a water-repellent agent can be mixed in the resin.

As a resin for the second material, thermoplastic resins such as polypropylene, polyethylene, PBT, PA, and PET can be used suitably. Preferably, the second material does not contain the above colorant so that the second material can absorb less laser light. However, the second material may contain the colorant. In this case, the mass content of the colorant in the second material is lower than that in the first material.

The support body 4 is opaque, and typically has a black color. This promotes the absorption of laser light and makes it easy to form the laser welding portions 12 and 14. The phrase "having a black color" means containing a colorant for imparting a black color. Generally, in terms of blackness defined as lightness (of achromatic colors) according to JIS Z 8721, a lightness of 1 to 4 is determined as "black", 5 to 8 as "gray", and 9 or more as "white". In the present embodiment, the support body 4 suffices as long as it is gray or black (blackness of 8 or less). Preferably, the support body 4 is black (blackness of 4 or less) in view of laser light absorption efficiency.

On the other hand, the cover 6 is preferably transparent so that the laser welding portion 12 and the gas-permeable membrane 2 can be visually recognized through the cover 6. When the cover 6 is transparent, the appearance of the laser welding portion 12 and the gas-permeable membrane 2 can be examined with the cover 6 attached. In addition, various tests such as tests for determining the water resistance of the gas-permeable membrane 2 and the presence or absence of foreign substances attached thereto can be carried out with the cover 6 fixed to the support body 4. Therefore, according to the present embodiment, not only defectives can be found easily but also an increase in productivity and quality of the product (vent member 10) can be expected.

The second material (the material of the cover 6) does not necessarily have to be transparent, and the second material may be opaque like the first material. In this case, the first material has a relatively lower blackness, while the second material has a relatively higher blackness.

When the gas-permeable membrane 2 and the support body 4 are joined together by the second laser welding portion 14, it is preferable that the support body 4 be made of the first material that easily absorbs laser light and the gas-permeable membrane 2 be made of a material that absorbs less laser light than the first material. With this configuration, the second laser welding portion 14 can be formed relatively easily by irradiating the interface between the gas-permeable membrane 2 and the support body 4 with laser light from the gas-permeable membrane 2 side. Specifically, it is preferable that the first material have a relatively low blackness and the constituent material of the gas-permeable membrane 2 have a relatively high blackness. Typically, it is preferable that the gas-permeable membrane 2 have a white calor, for example, a blackness of 9 or more. Preferably, the constituent material of the gas-permeable membrane 2 does not contain the above colorant so that the material can absorb less laser light. For example, since uncolored PTFE inherently has a white color, it is suitable as a material for the gas-permeable membrane 2.

As shown in Fig. 2 and Fig. 4, the cover 6 has a flat ceiling portion 31 facing the gas-permeable membrane 2 and a cylindrical eaves portion 32 extending downward from the ceiling portion 31 to the support body 4. The laser welding portion 12 is formed between the lower surface of the eaves portion 32 and the upper surface of the support body 4. With such a configuration, a sufficiently large space AR₁ can be easily maintained between the cover 6 and the gas-permeable membrane 2.

More specifically, the eaves portion 32 includes an inner peripheral portion 32a that overlaps the outer peripheral portion of the gas-permeable membrane 2 in the radial direction of the gas-permeable membrane 2 and an outer peripheral portion 32b that does not overlap the gas-permeable membrane 2 in the radial direction of the gas-permeable membrane 2. The first laser welding portion 12 is formed between the outer peripheral portion 32b of the eaves portion 32 and the support body 4. The second laser welding portion 14 is formed between the outer peripheral portion of the gas-permeable membrane 2 and the support body 4. The inner peripheral portion 32a of the eaves portion 32 overlaps the outer peripheral portion of the gas-permeable membrane 2, that is, the outer peripheral portion of the gas-permeable membrane 2 is sandwiched between the support body 4 and the cover 6. Therefore, it is possible to reliably prevent the gas-permeable membrane 2 from being detached from the support body 4. Furthermore, in the laser irradiation step for forming the second laser welding portion 14, the gas-permeable membrane 2 can be pressed against the support body 4 with the cover 6. That is, the cover 6 can also be used as a jig for the gas-permeable membrane 2.

As shown in Fig. 2, the cover 6 further has a vent hole 7 formed in the ceiling portion 31 to communicate the interior space (space AR₁) of the cover 6 with the exterior space 24. The vent hole 7 allows the first welding portion 12 to be formed entirely along the circumferential direction of the cover 6. That is, in the present embodiment, the first laser welding portion 12 has a ring shape in plan view. With such a configuration, the cover 6 can be firmly fixed to the support body 4. Likewise, since the second laser welding portion 14 has a ring shape, the gas-permeable membrane 2 can be firmly fixed to the support body 4. In addition, a plurality of vent holes 7 are formed at regular angular intervals along the circumferential direction of the ceiling portion 31. In the present embodiment, three vent holes 7 are formed at every 120 degrees. Therefore, even if a liquid such as water enters the interior space of the cover 6 through one vent hole 7, the liquid can be discharged to the exterior space through another vent hole 7.

The laser welding portions 12 and 14 may have a shape other than a ring shape in plan view, of course. For example, one or more vent holes opening in the horizontal direction may be formed in the eaves portion 32 of the cover 6 to communicate the interior space (space AR₁) of the cover 6 with the exterior space 24. In the case where such one or more vent holes are formed in the eaves portion 32, the first laser welding portion 12 may be cut at at least one position in the circumferential direction. Furthermore, in the case where such one or more vent holes are formed in the eaves portion 32, the vent hole 7 can be eliminated from the ceiling portion 31.

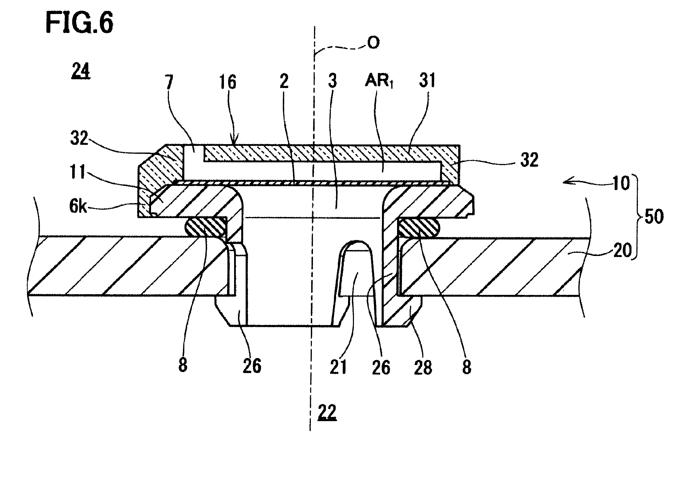

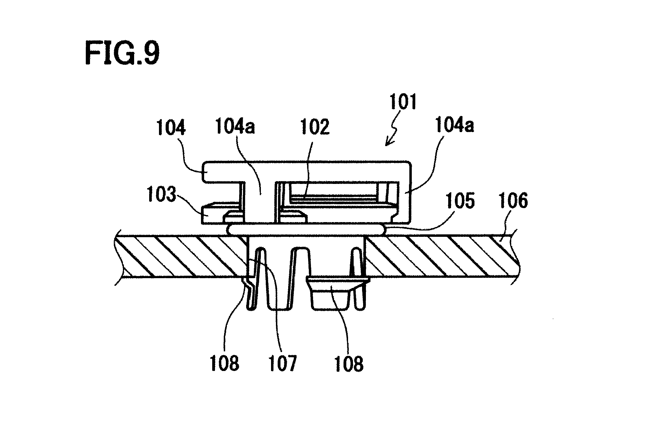

According to the present embodiment, the cover 6 is located completely inside the support body 4 in plan view. That is, unlike a conventional vent member (see Fig. 9), an engaging portion for fixing the cover to the support body can be eliminated from the cover. Such an engaging portion is usually provided on the outer peripheral portion of the cover. Therefore, the simplification and miniaturization of the vent member can be achieved by eliminating the engaging portion. Since the cover 6 has a very simple shape, it can be formed using a pair of molds, for example. The present invention does not exclude a conventional cover having an engaging portion, of course. A cover 16 having an engaging portion 6k capable of being engaged with the outer peripheral portion of the support body 4, as shown in Fig. 6, can be used instead of the cover 6 without an engaging portion. In the present embodiment, the outer diameter of the support body 4 is larger than that of the cover 6, but the outer diameter of the support body 4 may be equal to that of the cover 6.

Next, a method of manufacturing a vent member is described. First, the support body 4, the gas-permeable membrane 2, and the cover 6 are produced separately. The support body 4 and the cover 6 can be produced by a common molding method such as injection molding, compression molding or cutting, typically by injection molding. The surface of the support body 4 and the cover 6 may be subjected to water-repellent treatment for promoting the removal of liquid. The support body 4 and the cover 6 can further be subjected to other treatments such as an easy-adhesion treatment, insulating treatment, semiconductor treatment and conducting treatment.

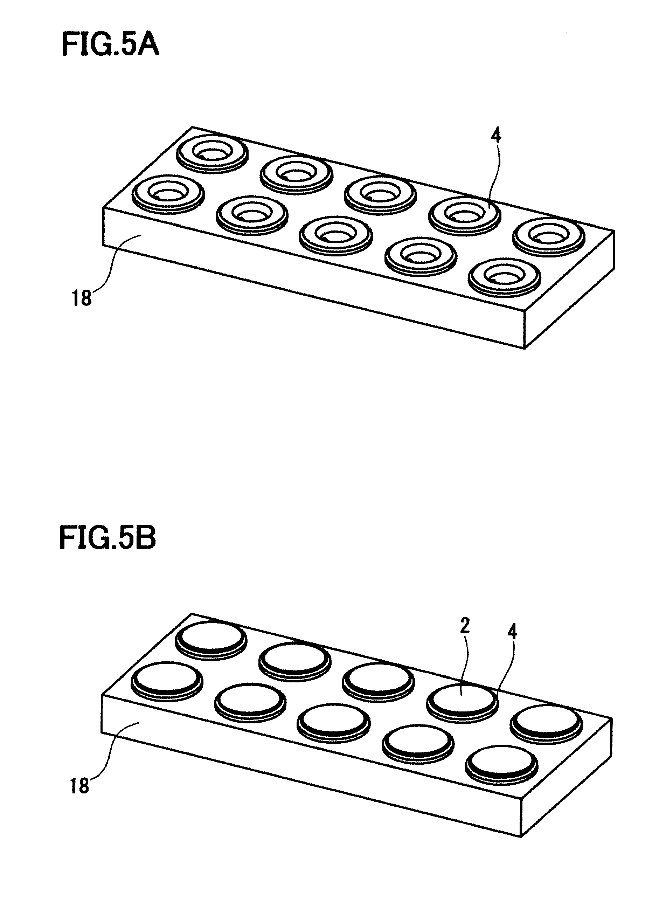

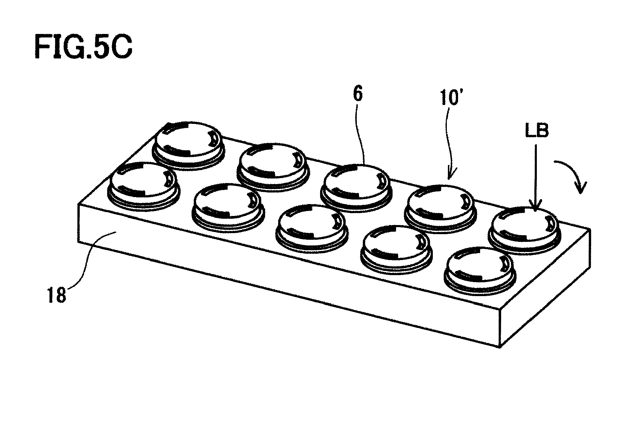

Next, the gas-permeable membrane 2 and the cover 6 are placed respectively at predetermined positions with respect to the support body 4. First, a plurality of support bodies 4 are mounted on a jig 18, as shown in Fig. 5A. The jig 18 can hold a plurality of support bodies 4 so that a plurality of vent members 10 can be assembled simultaneously. The support bodies 4 are held on the jig 18 in such a position that their upper surfaces are parallel to the horizontal direction. Next, the gas-permeable membrane 2 is placed on each of the support bodies 4 so that the center of the gas-permeable membrane 2 coincides with the axis O of the support body 4, as shown in Fig. 5B. The gas-permeable membrane 2 may be temporarily fixed to the support body 4 with an adhesive to keep the gas-permeable membrane 2 from moving. Next, the cover 6 is placed on the support body 4, as shown in Fig. 5C. As a result, an assembly 10' composed of the support body 4, the gas-permeable membrane 2 and the cover 6 is obtained.

Next, the assembly 10' composed of the support body 4, the gas-permeable membrane 2 and the cover 6 is irradiated with laser light so that the laser light passing through the cover 6 melts at least a part of the support body 4 to form the laser welding portion 12 for joining the cover 6 and the support body 4 together. In the case where the support body 4 is made of the second material described above and the cover 6 is made of the first material described above, the laser welding portion 12 can be formed when the laser light passing through the support body 4 melts at least a part of the cover 6.

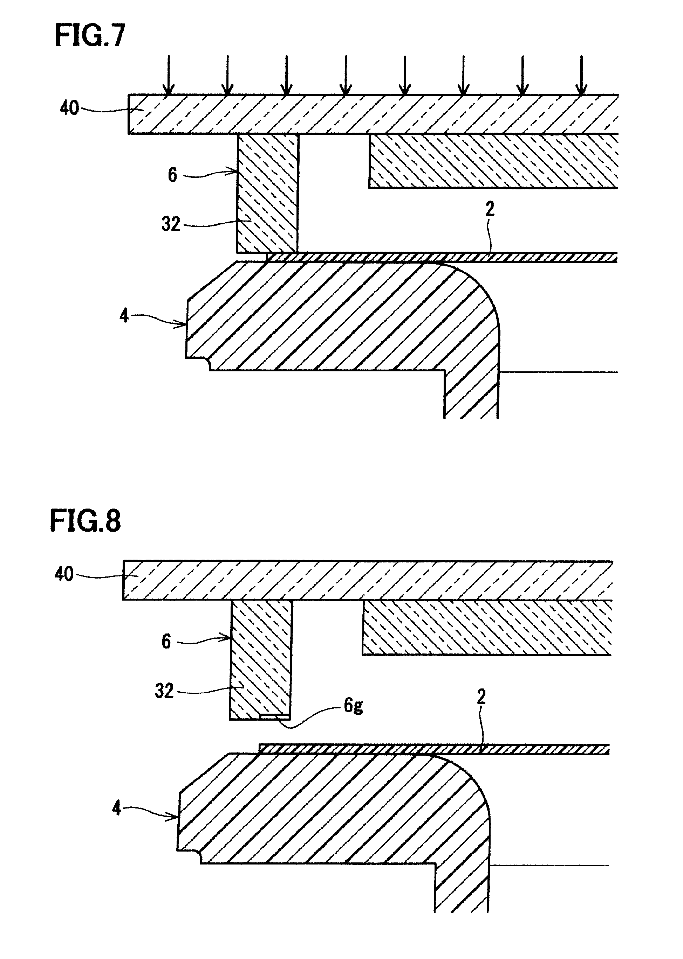

Specifically, as shown in Fig. 7, a jig 40 (typically a transparent glass sheet) that transmits laser light is placed on the cover 6 to cover it, and pressure is applied to the jig 40 so that the gas-permeable membrane 2 is sandwiched between the support body 4 and the cover 6. The assembly 10' in this state is irradiated with laser light, as described above. In the case where a counterbore 6g is formed in the cover 6 as shown in Fig. 8, the thickness of the gas-permeable membrane 2 is less likely to cause difficulty in forming the first laser welding portion 12 for joining the cover 6 and the support body 4 together. The counterbore 6g is formed in the lower surface of the eaves portion 32 of the gas-permeable membrane 2 so that the outer peripheral portion of the gas-permeable membrane 2 can be fitted into the counterbore 6g. The counterbore 6g has a depth, for example, about one third to one half of the thickness of the gas-permeable membrane 2. In the case of a thinner gas-permeable membrane 2, such a counterbore 6g is not needed.

In the present embodiment, the support body 4 is made of the first material that absorbs laser light easily, and the cover 6 is made of the second material that absorbs less laser light than the first material. Therefore, in the laser irradiation step, the interface between the eaves portion 32 of the cover 6 and the support body 4 is irradiated with laser light through the cover 6. Since the support body 4 has a leg portion 26, the support body 4 can be easily held by a jig. Therefore, the method of irradiating the interface with laser light through the cover 6 with the support body 4 held immobile makes sense from the viewpoint of design of the vent member 10.

In the present embodiment, when the assembly 10' is formed, the eaves portion 32 of the cover 6 includes the inner peripheral portion 32a that is to be in contact with the outer peripheral portion of the gas-permeable membrane 2 in the radial direction of the gas-permeable membrane 2 and the outer peripheral portion 32b that is to be in contact with the support body 4 in the radial direction of the gas-permeable membrane 2. In this case, the laser irradiation step can include the following first irradiation step (i) and the following second irradiation step (ii). The first irradiation step (i) is a step of irradiating the interface between the outer peripheral portion 32b of the eaves portion 32 and the support body 4 with laser light through the cover 6 so that the first laser welding portion 12 is formed between the outer peripheral portion 32b of the eaves portion 32 and the support body 4. The second irradiation step (ii) is a step of irradiating the interface between the outer peripheral portion of the gas-permeable membrane 2 and the support body 4 with laser light through the cover 6 so that the second laser welding portion 14 for joining the gas-permeable membrane 2 and the support body 4 together is formed between the outer peripheral portion of the gas-permeable membrane 2 and the support body 4. In this way, the first laser welding portion 12 and the second laser welding portion 14 can be formed efficiently, which increases the productivity of the vent member 10.

In the first irradiation step, when irradiated with laser light, the surface portion of the support body 4 is melted and solidified, so that the cover 6 and the support body 4 can be joined together. In the second irradiation step, when the surface portion of the support body 4 is melted and the molten resin penetrates into pores of a porous membrane (membrane body 2a) constituting the gas-permeable membrane 2. The resin that penetrates into the pores and is solidified produces an anchoring effect, and thereby, the gas-permeable membrane 2 is firmly fixed to the support body 4.

The conditions for the laser welding in the first irradiation step may be the same as or different from those for the laser welding in the second laser irradiation step. The conditions for the laser welding in each irradiation step should be adjusted as appropriate to prevent each component from being excessively damaged. For example, the laser output and laser wavelength are adjusted within the range of 20 to 300 W (or 20 to 50 W) and within the range of 800 to 1100 nm (or 800 to 950 nm), respectively. The type of laser is not particularly limited. A gas laser such as a CO₂ laser or an excimer laser, or a solid laser such as a semiconductor laser or a YAG laser (yttrium aluminum garnet laser) can be used.

In conventional heat welding, the accuracy of welding significantly depends on the degree of parallelism between a welding horn for applying heat to an interface and a welding abutment for holding work pieces (a gas-permeable membrane and a support body). However, in laser welding, errors derived from a processing device are less likely to be reflected in the quality of a finished product (a vent member). Therefore, an increase in the yield can be expected by employing laser welding.

It is also possible to weld the gas-permeable membrane 2 to the support body 4 before the cover 6 is placed on the support body 4. That is, the gas-permeable membrane 2 is welded to the support body 4 by a welding method such as laser welding, heat welding, or ultrasonic welding at the time shown in Fig. 5B. In this case, a welding portion (a laser welding portion, a heat welding portion, or an ultrasonic welding portion) for joining the gas-permeable membrane 2 and the support body 4 together is formed prior to the formation of the laser welding portion 12.

The vent member 10 described with reference to Fig. 1 to Fig. 4 can be manufactured by the method described above. Since the cover 6 is transparent in the vent member 10 of the present embodiment, the visual examination can be carried out easily. Therefore, defectives can be found easily, which is more advantageous for quality control purposes than conventional vent members.

### (Modification)

With the use of the support body made of a material having rubber elasticity, a vent member without a leg portion to be engaged with the opening 21 of the housing 20 can be provided. Such a vent member can be attached to the opening 21 of the housing 20 by means of the elasticity of the support body. In addition, it is conceivable that the "support body" may be a component that constitutes a part of the housing 20, for example, a component that constitutes the lid or the bottom of the housing 20.

In the example shown in Fig. 5A to Fig. 5C, many vent members 10 can be manufactured continuously. Here, an embodiment in which a single sheet made of the same material as the gas-permeable membrane 2 is used as the gas-permeable membranes 2 to be welded to the support bodies 4 is conceivable. In this case, this single sheet is placed on a plurality of support bodies 4 and each of the support bodies 4 is irradiated with laser light to form the second laser welding portion 14 thereon. Then, the single sheet is subjected to laser beam machining to obtain the gas-permeable membranes 2 having a predetermined shape (typically a circular shape) from that single sheet. This method can eliminate the need for handling each of the gas-permeable membranes 2 that have been cut into the predetermined shape.

Likewise, an embodiment in which a single plate made of the same material as the cover 6 is used as the covers 6 to be welded to the support bodies 4 also is conceivable. In this case, this single plate is placed on a plurality of support bodies 4 and each of the support bodies 4 is irradiated with laser light to form the first laser welding portion 12 thereon. Then, the single plate is subjected to laser beam machining to obtain the covers 6 having a predetermined shape (typically a circular shape) from that single plate. The through-holes 7 and the recesses corresponding to the spaces AR₁ are formed in the plate in advance to obtain the plurality of covers 6 from the single plate. This method can eliminate the need for handling each of the covers 6 that have been cut into the predetermined shape. Even if the plate is transparent, it can be cut by using a CO₂ laser (for example, with a wavelength of 10.6 µm in the far-infrared region and a lasing efficiency of 15 to 20%) or a YAG laser (for example, with a wavelength of 1.06 µm in the infrared region).

### INDUSTRIAL APPLICABILITY

The vent member of the present invention can be used for housings for automotive components such as lamps, motors, sensors, switches, ECUs, and gear boxes. The vent member of the present invention can be used not only for these automotive components but also for electronic products such as mobile communication devices, cameras, electric shavers, and electric toothbrushes.

## Claims

1. A vent member attachable to a housing with a vent opening, the vent member comprising:
a support body having a vent passage between an interior space and an exterior space of the housing;
a gas-permeable membrane disposed on the support body to close the vent passage on a side of the exterior space;
a cover attached to the support body to protect the gas-permeable membrane; and
a laser welding portion that joins the cover and the support body together.

2. The vent member according to claim 1, wherein
the support body is made of a first material that easily absorbs laser light for forming the laser welding portion,
the cover is made of a second material that absorbs less of the laser light than the first material and can transmit the laser light, and
the first and second materials contain the same type or different types of resins as main components.

3. The vent member according to claim 1, wherein the cover is transparent, and the laser welding portion and the gas-permeable membrane can be visually recognized through the cover.

4. The vent member according to claim 1, further comprising a second laser welding portion that joins the gas-permeable membrane and the support body together.

5. The vent member according to claim 1, wherein
the cover has a ceiling portion facing the gas-permeable membrane and an eaves portion extending downward from the ceiling portion to the support body, and
the laser welding portion is formed between a lower surface of the eaves portion and an upper surface of the support body.

6. The vent member according to claim 4, wherein
the cover has a ceiling portion facing the gas-permeable membrane and an eaves portion extending downward from the ceiling portion to the support body,
the eaves portion includes an inner peripheral portion that overlaps an outer peripheral portion of the gas-permeable membrane in a radial direction of the gas-permeable membrane and an outer peripheral portion that does not overlap the gas-permeable membrane in the radial direction of the gas-permeable membrane,
the laser welding portion as a first laser welding portion is formed between the outer peripheral portion of the eaves portion and the support body, and
the second laser welding portion is formed between the outer peripheral portion of the gas-permeable membrane and the support body.

7. The vent member according to claim 5, wherein
the cover further has a vent hole formed in the ceiling portion to communicate an interior space of the cover with the exterior space, and
the laser welding portion has a ring shape in plan view.

8. The vent member according to claim 1, wherein the cover is located completely inside the support body in plan view.

9. A method of manufacturing a vent member attachable to a housing with a vent opening, the method comprising the steps of:
preparing a support body having a vent passage between an interior space and an exterior space of the housing, a gas-permeable membrane capable of closing the vent passage on a side of the exterior space, and a cover to be attached to the support body to protect the gas-permeable membrane;
placing the gas-permeable membrane and the cover respectively at predetermined positions with respect to the support body; and
irradiating an assembly composed of the support body, the gas-permeable membrane and the cover with laser light so that the laser light passing through the cover melts a part of the support body or the laser light passing through the support body melts a part of the cover to form a laser welding portion for joining the cover and the support body together.

10. The method of manufacturing a vent member according to claim 9, wherein
the support body is made of a first material that easily absorbs the laser light for forming the laser welding portion,
the cover is made of a second material that absorbs less of the laser light than the first material and can transmit the laser light,
the cover has a ceiling portion facing the gas-permeable membrane and an eaves portion extending downward from the ceiling portion to the support body, and
in the laser irradiation step, an interface between the eaves portion and the support body is irradiated with the laser light through the cover.

11. The method of manufacturing a vent member according to claim 10, wherein
the eaves portion includes an inner peripheral portion that is to be in contact with an outer peripheral portion of the gas-permeable membrane in a radial direction of the gas-permeable membrane and an outer peripheral portion that is to be in contact with the support body in the radial direction of the gas-permeable membrane, and
the laser irradiation step includes the steps of: (i) irradiating the interface between the outer peripheral portion of the eaves portion and the support body with the laser light through the cover so that the laser welding portion is formed between the outer peripheral portion of the eaves portion and the support body; and (ii) irradiating an interface between the outer peripheral portion of the gas-permeable membrane and the support body with the laser light through the cover so that a second laser welding portion for joining the gas-permeable membrane and the support body together is formed between the outer peripheral portion of the gas-permeable membrane and the support body.
